# EUROPEAN PATENT SPECIFICATION

(11) **EP 0 728 223 B1**
(45) Date of publication and mention of the grant of the patent: **27.08.1997**
(21) Application number: 95902464.7
(22) Date of filing: 07.11.1994
(51) Int. Cl.: C23C 14/22, C22C 14/00, C23C 14/14, C23C 14/30

(54) **SUPERPLASTIC TITANIUM BY VAPOR DEPOSITION**
SUPERPLASTISCHES TITAN DURCH ABSCHEIDUNG AUS DER DAMPFPHASE
TITANE SUPERPLASTIQUE PRODUIT PAR DEPOT PAR EVAPORATION SOUS VIDE

(30) Priority: 08.11.1993 US 149437
(43) Date of publication of application: 28.08.1996
(73) Proprietor: UNITED TECHNOLOGIES CORPORATION, Hartford, Connecticut 06101 (US)
(72) Inventor: MOVCHAN, Boris B., Kiev, 252004 (UA); KORZH, Alexander V., Kiev, 252033 (UA); LEMKEY, Franklin D., Windsor, CT 06095 (US); SNOW, David B., Glastonbury, CT 06033 (US)
(74) Representative: Schmitz, Jean-Marie
(86) International application number: US9412807
(87) International publication number: WO9513406

(56) References cited:
- GB-A- 2 224 040
- US-A- 4 299 626
- US-A- 5 021 084
- US-A- 5 242 479
- SUPERPLASTICITY AND SUPERPLASTIC FORMING, The Minerals, Metals and Materials Society, issued 1988 I.I. NOVIKOV et al. "Optimization of Heterogeneity as General Principle of Controlling Alloys Structure for Superplastic Forming", pages 401-406 (cited in the application).

## Description

### Technical Field

This invention relates to superplastic titanium alloys and to the vapor deposition of titanium alloys.

### Background Art

Titanium alloys are widely used in aerospace applications, especially for rotating parts in gas turbines engines. Titanium alloys have many attractive engineering properties which include useful mechanical properties such as strength, creep resistance and fatigue resistance over a wide temperature range, combined with low density and relatively good resistance to corrosion and oxidation at moderate temperatures. Unfortunately alloys of titanium are difficult to form and difficult to machine at high metal removal rates. These factors can raise the cost of many complex titanium structures to uneconomic levels.

Superplasticity is a useful, widely studied and complex phenomenon. Materials which exhibit superplastic behavior will exhibit neck-free plastic extensions of at least 100% measured in a 2.54cm [one inch] gage length tensile specimen when tested at a strain rate between 4x10⁻⁵ per second to 1x10⁻³ per second. Extensions of more than 150% are preferred. Materials which exhibit superplastic behavior can readily be formed into complex shapes, shapes which can eliminate the need for much machining. The subject of superplasticity is explained in the following technical publications which are incorporated herein by reference (see attached):
1. Hamilton & Ghosh, *Chracterization of Superplastic Deformation Properties of Ti-6A1-4V*, TITANIUM 80 - SCIENCE AND TECHNOLOGY, H. Kimura and O. Izumi, eds., TMS-AIME, Warrendale, PA, 1980, pp. 1001-1014.
2. N. Furushiro et al., *Factors Influencing the Ductility of Superplastic Ti-6A1-4V Alloy*, in TITANIUM 80 - SCIENCE AND TECHNOLOGY, H. Kimura and O. Izumi, eds., TMS-AIME, Warrendale, PA, 1980, pp. 993-1000.
3. M.E. Rosenblum et al., *Microstructural Aspects of Superplastic Forming of Titanium Alloys*, in TITANIUM 80 - SCIENCE AND TECHNOLOGY, H. Kimura and O. Izumi, eds., TMS-AIME, Warrendale, PA, 1980, pp. 1015-1024.
4. I.I. Novikov and V.K. Portnoy, *Optimization of Heterogeneity as General Principal of Controlling Alloys Structure for Superplastic Forming*, in SUPERPLASTICITY AND SUPERPLASTIC FORMING, C.H. Hamilton and N.E. Paton, eds., The Minerals and Materials Society, Warrendale, PA, 1988, pp. 401-406.
5. N.E. Paton and C.H. Hamilton, *Microstructural Influences on Superplasticity in Ti-6A1-4V.*, Metall. Trans A, vol. 10A, 1979, pp. 241-249.

Great effort has gone into the development of superplactic forming processes for titanium alloys. Many such processes exist and are widely used. See for example U.S. Patent No.: 4,886,559, U.S. Patent No.: 4,299,626, and U.S. Patent No.: 4,944,914. An apparent universal feature of prior art superplastic titanium processes has been the use of an elevated working temperature, usually about 980°C and invariable above about 890°C. The prior art processes arc useful and are widely employed to form complex titanium articles. But, the prior art processes are still expensive. The common drawback to the prior art processes is the relatively elevated temperatures at which they must be performed. At elevated temperatures, above about 650°C to 760°C, and in the presence of oxygen, titanium is subject to rapid oxidation and rapid absorption of oxygen atoms into the lattice. Oxygen tends to embrittle titanium and is known to be a stabilizer of the alpha phase. Consequently, alpha plus beta titanium alloys, which are the most widely used class titanium alloys, are prone to the formation of a deleterious surface layer known as an alpha case when exposed to oxygen in temperatures in excess of about 650°C. This alpha case reduces the properties of titanium and generally must be removed physically or chemically prior to the use of such articles in service.

For this reason the prior art superplastic titanium forming processes which are performed at temperatures in excess of about 900°C are invariably performed in an inert or vacuum atmosphere. The requirement for such atmospheres adds substantial costs to the forming process not only in added equipment costs but in increased cycle times and costs for furnace atmospheres and the like. In addition, the oxidation of titanium alloys at these temperatures is still a common problem despite the use of inert atmospheres because of the difficulty of maintaining a sufficiently pure atmosphere.

Accordingly there exists a need for a method produce titanium alloys which can be superplastically formed at temperatures below which oxidation and oxygen contamination oftitanium is a significant problem.

In this application, unless otherwise noted, compositions are presented to weight percent and phase and particle quantities are presented in volume percent.

### Summary of the Invention

It is therefore the object ofthe present invention to describe a titanium material, and a method for producing such material, which can be superplastically formed at conditions below about 760°C and preferably below 650°C and which can therefore be superplastically formed at temperatures where oxidation is not a problem even in ambient atmospheres.

Superplasticity is a concept without an exact definition. Generally the term superplasticity refers to metallic material exhibiting tensile elongations much in excess of that which normally be observed. While for a normal metallic material a typical tensile stress might show an elongation of between 5% and 50%, superplastic material when tested at the appropriate elevated temperature can show an elongation of as much as 1500%. For the purpose ofthis disclosure, superplasticity will be defined as a elongation of more than 100% and preferably more than 150% and most preferably be in excess of about 200 when measured in the temperature range of about 460°C to 560°C. Superplasticity has been the subject of great study for many years and many different observations and theories have resulted. It now seems that superplasticity results in large measure from grain boundary sliding, the movement of one grain relative to another in a direction lying in a plane which direction parallel to the plane separating the grains. Of course this grain boundary sliding must be accompanied by grain deformation to prevent the formation of voids or cavities. In titanium alloys it is known that grain boundary sliding along grain boundaries separating alpha grains is the most difficult to achieve. Grain boundary sliding along a boundary separating an alpha grain from a beta grain is the easiest type of deformation while boundaries sliding between two beta grains is intermediate between the previously described situations.

Consequently, the achievement of superplasticity in all alpha material is substantially more difficult than the achievement of superplasticity in material containing a mixture of alpha grains and beta grains. Achievement of superplasticity in all beta material has not been extensively studied but we believe it would be intermediate between the all alpha case and the alpha beta case.

Conventional superplastic titanium alloys are found to contain substantially equal volumes of the alpha and beta phase. It has been speculated that equal amounts of alpha and beta phases produce the ultimate possible degree of superplasticity. However, in accordance with the present invention, we have obtained 400% elongation in material containing 10% to 20% of the beta phase. This suggests the possibility that increasing the amount ofthe beta phase in materials made according to the present invention might further increase the degree of available superplasticity.

Because the superplasticity varies between the alpha/alpha situation, the alpha/beta situation and the beta/beta situation, the invention will be described first with respect to the alpha/beta situation which has been the most extensively studied and then with respect to the other conditions.

A major aspect of the invention is the method of making an extraordinarily fine grained titanium alloy through high-rate vacuum vapor deposition (e.g. at least 35 µm (microns) and preferably 50 µm (microns) to 100 µm (microns) per minute). The most commercially significant embodiment relates to alpha-beta titanium alloys such as 6% Al, 4% V bal Ti. The alloy composition and the vapor deposition parameters (substrate temperature) are selected so that the deposited fine grained alloy is in a non equilibrium condition containing more alpha phase than would be observed at equilibrium conditions. This excess alpha phase is metastable.

The result is a material which starts out being superplastic by virtue of its initial fine grain size and remains superplastic during deformation at elevated temperatures as a consequence ofthe transformation of the excess metastable alpha phase to beta phase at the boundaries between the original fine alpha grains. This beta precipitation between the original fine alpha grains effectively inhibits grain growth ofthe original alpha grains.

Consequently, titanium articles with this particular microstructure and processing history have the requisite properties to accomplish the above enumerated objects ofthe invention.

The initial fine grain size is accomplished by vacuum vapor deposition, preferably using an electron beam heat source. The evaporated titanium alloy vapor is collected on a cool substrate. As used herein cool is a relative term denoting that the substrate is cool relative to the temperature of the molten titanium vapor from which condensation is occurring. Substrate (deposition) temperature appears to be critical. Too high a temperature will result in an excessive grain size and too low a substrate temperature will result in a porous deposit. Condensation temperatures between about 500°C and 680°C are required.

The fine grained, partially metastable, titanium is removed from the substrate and deformed at temperatures between about 500°C and 535°C and when deformed under a strain rate of between about of at least about 1.7 x 10⁻³ and 1.7x10⁻⁴, respectively, exhibits deformations in excess of 200%.

According to the invention, if no insoluble particles are present, the starting titanium composition must be an alpha beta alloy containing at least about 3% to 5% beta phase after vapor deposition and preferably at least about 10% to over 50% beta phase at the deformation temperature

It is also possible to add insoluble particles such as borides and rare earth oxides. Such particles can aid in preserving the fine grain size during deformation. As discussed below, such particles appear to be necessary in single phase alloys (all alpha or all beta) and optional in the case of alpha-beta alloys. The particle discussion below has equal applicability to alpha-beta alloys but is optional in such systems.

### Detailed Disclosure

We believe that alpha alloy behave as alpha alloys with as much as about 5% beta phase at the grain boundaries. At the other end of the range, near beta alloys can tolerate as much as 3% alpha at the grain boundaries before they behave as alpha beta alloys

Alpha Plus Beta Titanium Alloys. According to the present invention, alloys containing from about 10% to over 50%. volume beta at the superplastic forming temperature, are formed by vacuum vapor deposition on a substrate. The deposition process is performed under conditions which result in an extraordinarily fine grain size of less than about 2 µm (microns) and most preferably less than about 1 µm (micron) in the as deposited material as measured in a plane parallel to the substrate.

The vapor is evaporated from a molten pool of the titanium alloy using a heat source such as an electron beam U S. Patent No.: 5,242,479 discusses an exemplary apparatus in the context of producing carbide coatings. The resultant vapor is condensed on a relatively cool substrate to form a homogeneous dense deposit having a columnar grain structure. The columnar grains have their long or columnar axis perpendicular to the substrate and have a typical grain diameter in a plane parallel to the substrate of less than 2 µm (microns) and preferably less than 1 µm (micron) and have an aspect ratio, the ratio of the short diameter in a plane parallel to the substrate to the long dimension, in a plane perpendicular to the substrate, of from about 3 to 1 to about 100 to 1. Superplasticity inevitably requires a fine grain size. The present invention deposition process produces grains which meet the requirements for superplasticity in two dimensions, but not in a third dimension and superplasticity will initially be most apparent in planes containing the small dimensions of the grains. That is to say the full extent of superplasticity may not initially be observed when stress is applied in a direction parallel to the columnar axis of the grains. However, it is observed that after about 50% to 100% deformation the grains become equiaxed and thereupon display superplasticity in an isotropic fashion. We believe that the described columnar titanium structure is novel, useful, and non-obvious.

The particular techniques of physical vacuum vapor deposition do not appear to be critical to the success to the invention so long as the essential microstructure is achieved. We have used apparatus such as that described in U.S. Patent No.. 5,242,479. The major advantage of the apparatus described in these patents is the high rate of deposition which can be achieved. This is however mainly a matter of economics rather than the properties of the resultant deposited material. Consequently, other forms of deposition appear possible. These include processes such as those depicted in U.S. Patent No.. 3,615,275 and U.S. Patent No.: 5,021,084, as well as other potential processes such as sputtering. Sputtering however is characterized by very low deposition rates rendering it unlikely to be an economical approach to the present invention. The apparatus in U.S. Patent No.: 5,242,479 is also desired because it can be adapted for co-evaporation to produce titanium materials containing particles easily.

It is important that the deposition be performed in a vacuum of at least 13.3 mPa [10⁻⁴ millimeters of mercury] because of the high affinity of Ti for oxygen. In the work done to date the titanium vapor has been deposited on a substrate which is beld about 20 centimeters above the molten titanium vapor source. The temperature of the substrate is critical to the successful performance of the present invention. If the substrate temperature is less than about 500°C the resultant deposits are porous and not useful. When the substrate deposition temperature is in excess of about 700°C the grain sized of the as deposited material is greater than about 3 µm (microns) and the desired superplastic behavior at low temperatures is not observed. Only a narrow substrate (condensation) temperature range from about 500°C to about 680°C and preferably about 550°C to 650°C permits the deposition of titanium alloys satisfying the needs of the present invention for starting material. It should be noted here that the substrate temperatures are difficult to monitor.. The substrate is located in the vapor cloud of titanium which is an extraordinarily reactive environment. This inhibits the use of direct surface contact instrument such as thermocouples. The titanium vapor cloud also interferes with optical perimetry. Consequently, we have measured the temperature at the back side of the substrate and using conventional thermodynamic calculations have been able to estimate closely the temperature ofthe front face ofthe substrate where the titanium is being deposited. During the deposition of thick layers of titanium the resistance to heat flow of the combined substrate and titanium coating increase as the coating thickness increases and we have compensated for this in our calculations. Other artisans who approach the practice of this invention using different equipment and different substrate materials and substrate geometries will necessarily have to devise their own methods for measuring and estimating the substrate surface temperature. It is clearly within the skill of one skilled in the art to practice the present invention merely by noting the substrate temperature at a place where such temperature can be conveniently measured and correlating the measured temperature with the characteristic grain size ofthe material deposited.

In our high rate deposition apparatus described in the papers mentioned above deposition rates on the order of 100 µm (microns) per minute have been achieved. These higher deposition rates resulted in increased heat flux to the substrate and require careful attention to substrate temperature. In our work to date we have used a monolithic substrate coated with a fluoride parting compound without specific provisions for cooling except such cooling as occurs by natural radiation. The parting agent appears to be optional. It is fully within the scope ofthis invention to employ auxiliary fluid cooling within the substrate or at the back face of the substrate to moderate and control substrate temperatures to achieve the desired objectives ofthe present invention.

As previously described the titanium alloy produced according to the invention has an initial fine grain size which permits low temperature superplastic forming. Under normal circumstances in a typical titanium alloy such a fine grain structure would not persist at the deformation temperatures involved since rapid grain growth would occur, and once the grains grew to sizes much in excess of about 2 µm (microns) the superplastic behavior would be lost. What makes the present invention material unique is that as deposited it is in a metastable state because the vacuum vapor deposition process produces a high effective cooling rate. Such a high cooling rate suppresses the formation of the equilibrium quantity beta phase which would exist at the equilibrium. Upon heating to the deformation temperature this suppressed beta precipitates at the boundaries between the original alpha grains stabilizing such boundaries against motion associated with grain growth and thereby effectively preventing deleterious grain growth, while enhancing grain boundary sliding. This phenomenon permits extended superplasticity at the processing temperatures used permitting the forming of the alpha-beta alloy over a relatively long time period, permitting the forming of complex geometries and permitting the use of multiple deformation steps. At the conclusion of the deformation process the material can be heated to an elevated temperature sufficient to cause grain growth. Once the grains grow much above about 3 µm (microns) the lower-temperature superplastic effect is lost and the titanium thereupon exhibits the mechanical properties found in any other titanium alloy of similar composition and similar grain size. The alloy composition suitable for use in the present process can be described as alpha plus beta alloys which have an equilibrium beta content of at least about 10% at the intended deformation temperature. TABLE I below lists a variety of alloys which can be satisfactorily processed according to the present invention.

**TABLE I**

| | |
|---|---|
| Alpha Beta Alloys (wt%) | Ti-6A1-4V |
| | Ti-6A1-25n-42r-2Mo |
| | Ti-5A1-2.55n |
| Beta Alloys | Ti-15V-3Cr-3Sn-3A1 |
| Alpha Alloys | Commercially Pure Ti |

We have worked almost exclusively with an alloy based upon the common titanium alloy whose nominal composition is 6% aluminum 4% vanadium balance titanium. Experimental equipment deficits generally resulted in the deposition of an alloy containing more vanadium than aluminum. Nonetheless the resultant alloy contains necessary beta phase and exhibited the superplasticity which is the essence ofthe invention.

All Alpha and All Beta Alloys. The previously described alpha-beta alloys such as Ti -6%, Al 4% V achieve and maintain superplasticity, in the practice of the invention, primarily through the metastable alpha to beta transformation mentioned above. Such a mechanism cannot be operative when the titanium material is not metastable but is especially single phase (either all alpha or all beta) at the deformation temperature.

We have achieved useful superplasticity in such non-metastable, single phase materials by adding a fine precipitate distribution to stabilize the grain size during superplastic deformation. The starting grain size in such systems is achieved by the same vapor deposition techniques (and substrate temperature control) as discussed with respect to alpha-beta alloys.

Principally we have developed and successfully employed a titanium mono-boride particle distribution. We have also employed rare earth oxides as stabilizing particles.

To produce TiB particle distribution it is necessary to supply a source of boron and to co-evaporate boron along with the titanium material. We use an apparatus like that shown in U.S. Patent No.: 5,242,479 and adjust the relative evaporation rates so as to produce up to 15.0% by volume of TiB particles in the deposited layer, preferably 0.5% to 5.0% by volume. TiB is extremely stable and insoluble in titanium and the resultant particles have average diameters of less than about 200°A (preferably less than 150°A) and average inter-particle spacings of less than about 2,000°A (preferably less than 1,000°A). The partide size and spacing are affected by the substrate temperature and deposition rate. For boron sources we have used ZrB₂ (the resultant Zr level in the material is not a problem) but are confident that other compounds such as TiB, TiB₂, B and the borides of Aluminium and Vanadium could be used.

We have also employed rare earth oxides such as those based on the group 3b elements in the Periodic Table and the Lanthanides.

The development of rare earth dispersions exactly parallel the previously-mentioned preparation of TiB dispersion. The source may be either the rare earth oxide or simply the pure rare earth. If the pure rare earth is employed, it will be found that sufficient oxygen will be present as an impurity to fully oxidize the rare earth.

It is also possible to us both TiB and rare earth oxide particles in single material by using a triple co-evaporation scheme. TiB is usually preferred because it is more stable than the rare earth oxides.

Although the invention has been shown and described with respect to preferred embodiments and application to certain titanium alloys, it should be evident to those skilled in the art that it is applicable to a wide variety of titanium alloys and that various changes made therein.

## Claims

1. A method for producing a titanium or titanium alloy material which exhibits superplastic properties at temperatures below about 760°C including the steps of:
a. co-evaporating a titanium alloy and a material selected from the group consisting of boron sources, rare earths, rare earth compounds and rare earth alloys and mixtures thereof, in a vacuum of less than 13.3 m Pa, at relative rates so that the titanium alloy comprises at least about 85% volume of the total evaporated material;
b. condensing the co-evaporated material onto a substrate maintained at a temperature of between about 500°C and 680°C,
Whereby the resultant condensed material contains a dispersion of particles selected from the group consisting of TiB and rare earth oxides and mixtures thereof, said particles having average diameters of less than about 200A° [200°] and average inter-particle spacings of less than about 1000A°[1,000°], and has a grain size of less than about 2 µm (microns) in a plane parallel to the substrate.

2. A titanium material, said material
a. having an average grain size of less than about 2 µm (microns) measured in at least one plane and consisting in part of metastable alpha phase;
b. exhibiting a tensile elongation in excess of about 150% when tested a temperature of less than about 650°C when the major stress axis essentially lies in a plane in which the measured grain diameter is less than about 2 µm (microns).

3. A titanium material, said material:
a. having an average size of less than about 2 µm (microns) measured in at least one plane and consisting in part of metastable alpha phase containing up to 2.5 volume of finely dispersed stable particles;
b. exhibiting a tensile elongation in excess of about 150% when tested a temperature of less than about 650°C when the major stress axis essentially lies in a plane in which the measured grain diameter is less than about 2 µm (microns).

4. A titanium material as in claim 3 wherein the particles have an average diameter of lees than about 200A° [200°] and an average inter-particle spacing of less than about 1000A°[1,000°].

5. A titanium material as in claim 3 wherein the particles are selected from the group consisting of TiB and rate earth oxides and mixtures thereof.

6. A titanium material as in claim 3 wherein the particles are essentially TiB.

7. A titanium material as in claim 3 wherein the particles are essentially rare earth oxides.

8. A titanium material, said material:
a. having an average grain size of less than about 2 µm (microns) measured in at least one plane and consisting essentially of alpha grains containing 0.5% volume to 2.5% volume of finely dispersed stable particles;
b. exhibiting a tensile elongation in excess of about 150% when tested a temperature of less than about 650°C when the major stress axis essentially lies in a plane in which the measured grain diameter is less than about 2 µm (microns).

9. A titanium material as in claim 8 wherein the particles have an average diameter of less than about 200A° [200°] and average inter-particle spacing of less than about 1000A° [1,000°].

10. A titanium material as in claim 8 wherein the particles are selected from the group consisting of TiB and rate earth oxides ans mixtures thereof.

11. A titanium material as in claim 8 wherein the particles are essentially TiB.

12. A titanium material as in claim 8 wherein the particles are essentially rare earth oxides.

13. A titanium material, said material:
a. having an average grain size of less than about 2 µm (microns) measured in at least one plane and consisting essentially of beta grains containing 0.5% volume to 2.5% volume of finely dispersed stable particles;
b. exhibiting a tensile elongation in excess of about 150% when tested a temperature of less than about 650°C when the major stress axis essentially lies in a plane in which the measured grain diameter is less than about 2 µm (microns).

14. A titanium material as in claim 13 wherein the particles have an average diameter of less than about 200A° [200°] and an average inter-particle spacing of less than about 1000A° [1,000°].

15. A titanium material as in claim 13 wherein the particles selected from the group consisting of TiB and rare earth oxides and mixtures thereof.

16. A titanium material as in claim 13 wherein the particles are essentially TiB.

17. A titanium material as in claim 13 wherein the particles are essentially rare earth oxides.

## Patentansprüche

1. Verfahren zum Herstellen eines Titan- oder Titanlegierungsmaterials, welches superplastische Eigenschaften bei Temperaturen unterhalb von etwa 760°C zeigt, umfassend die Stufen:
a. Coverdampfen einer Titanlegierung und eines Materials, ausgewählt aus Borquellen, Seltenerden, Seltenerdverbindungen und Seltenerdlegierungen und Mischungen davon, in einem Vakuum von weniger als 13,3 mPa bei relativen Raten, so daß die Titanlegierung mindestens etwa 85 Vol.% des gesamten verdampften Materials enthält,
b. Kondensieren des coverdampften Materials auf einem Substrat, welches auf einer Temperatur von zwischen etwa 500°C und 680°C gehalten wird,
wodurch das sich ergebende kondensierte Material eine Dispersion von Teilchen ausgewählt aus TiB und Seltenerdoxiden und Mischungen davon enthält, wobei die Teilchen Durchschnittsdurchmesser von weniger als etwa 200°A [200°] und Durchschnittszwischenteilchenabstände von weniger als etwa 1000A° [1000°] haben, und eine Korngröße von weniger als etwa 2 µm (Mikrons) in einer Ebene parallel zu dem Substrat hat.

2. Titanmaterial, wobei das Material
a. eine Durchschnittskorngröße von weniger als etwa 2 µm (Mikrons), gemessen in mindestens einer Ebene, hat und teilweise aus metastabiler alpha Phase besteht,
b. eine Zugdehnung über etwa 150 % beim Testen einer Temperatur von weniger als etwa 650°C zeigt, wenn die Hauptbeanspruchungsachse im wesentlichen in einer Ebene liegt, in der der gemessene Korndurchmesser weniger als etwa 2 µm (Mikrons) beträgt.

3. Titanmaterial, wobei das Material
a. eine Durchschnittskorngröße von weniger als etwa 2 µm (Mikrons), gemessen in wenigstens einer Ebene, hat und teilweise aus metastabiler alpha Phase besteht, die bis zu 2,5 Volumen fein dispergierte stabile Teilchen enthält,
b. eine Zugdehnung über etwa 150 % beim Testen einer Temperatur von weniger als etwa 650°C zeigt, wenn die Hauptbeanspruchungsachse im wesentlichen in einer Ebene liegt, in der der gemessene Korndurchmesser weniger als etwa 2 µm (Mikrons) beträgt.

4. Titanmaterial nach Anspruch 3, wobei die Teilchen einen Durchschnittsdurchmesser von weniger als etwa 200A° [200°] und einen Durchschnittszwischenteilchenabstand von weniger als etwa 1000A° [1000°] aufweisen.

5. Titanmaterial nach Anspruch 3, wobei die Teilchen aus TiB und Seltenerdoxiden und Mischungen davon ausgewählt sind.

6. Titanmaterial nach Anspruch 3, wobei die Teilchen im wesentlichen TiB sind.

7. Titanmaterial nach Anspruch 3, wobei die Teilchen im wesentlichen Seltenerdoxide sind.

8. Titanmaterial, wobei das Material
a. eine Durchschnittskorngröße von weniger als etwa 2 µm (Mikrons), gemessen in wenigstens einer Ebene, aufweist und im wesentlichen aus alpha Körnern besteht, die 0,5 Vol.% bis 2,5 Vol.% fein dispergierte stabile Teilchen enthalten,
b. eine Zugdehnung über etwa 150 % beim Testen einer Temperatur von weniger als etwa 650°C zeigt, wenn die Hauptbeanspruchungsachse im wesentlichen in einer Ebene liegt, in der der gemessene Korndurchmesser weniger als etwa 2 µm (Mikrons) beträgt.

9. Titanmaterial nach Anspruch 8, wobei die Teilchen einen Durchschnittsdurchmesser von weniger als etwa 200A° [200°] und einen Durchschnittszwischenteilchenabstand von weniger als etwa 1000A° [1000°] haben.

10. Titanmaterial nach Anspruch 8, wobei die Teilchen aus TiB und Seltenerdoxiden und Mischungen davon ausgewählt sind.

11. Titanmaterial nach Anspruch 8, wobei die Teilchen im wesentlichen TiB sind.

12. Titanmaterial nach Anspruch 8, wobei die Teilchen im wesentlichen Seltenerdoxide sind.

13. Titanmaterial, wobei das Material
a. eine Durchschnittskorngröße von weniger als etwa 2 µm (Mikrons), gemessen in wenigstens einer Ebene, aufweist und im wesentlichen aus beta Körnern besteht, die 0,5 Vol.% bis 2,5 Vol.% fein dispergierte stabile Teilchen enthalten,
b. eine Zugdehnug über etwa 150 % beim Testen einer Temperatur von weniger als etwa 650°C zeigt, wenn die Hauptbeanspruchungsachse im wesentlichen in einer Ebene liegt, in der der gemessene Korndurchmesser weniger als etwa 2 µm (Mikrons) beträgt.

14. Titanmaterial nach Anspruch 13, wobei die Teilchen einen Durchschnittsdurchmesser von weniger als etwa 200°A [200°] und einen Durchschnittszwischenteilchenabstand von weniger als etwa 1000A° [1000°] haben.

15. Titanmaterial nach Anspruch 13, wobei die Teilchen aus TiB und Seltenerdoxiden und Mischungen davon ausgewählt sind.

16. Titanmaterial nach Anspruch 13, wobei die Teilchen im wesentlichen TiB sind.

17. Titanmaterial nach Anspruch 13, wobei die Teilchen im wesentlichen Seltenerdoxide sind.

## Revendications

1. Un procédé pour produire une matière en titane ou en alliage de titane qui présente des propriétés superplastiques à des températures inférieures à environ 760°C comprenant les étapes de:
a. co-évaporer un alliage de titane et une matière choisie dans le groupe consistant en source de bore, de terres-rares, composés de terres-rares et alliages de terres-rares et des mélanges de ceux-ci, dans un vide de moins de 13,3 mPa, à des vitesses relatives telles que l'alliage de titane comprend au moins 85% en volume de la matière évaporée totale.
b. condenser la matière co-évaporée sur un substrat maintenu à une température entre environ 500°C et 680°C, de sorte que la matière condensée résultante contient une dispersion de particules choisies dans le groupe consistant en TiB et oxydes de terres-rares et mélanges de ceux-ci, ces particules ayant des diamètres moyens inférieurs à environ 200 Å [200°] et des écartements inter-particules moyens inférieurs à environ 1000 Å [1000°] et à une dimension de grains inférieure à environ 2 µm (microns) dans un plan parallèle au substrat.

2. Une matière de titane, cette matière:
a. ayant une dimension de grains moyenne de moins d'environ 2 µm (microns) mesurée dans au moins un plan et consistant en partie en phase alpha métastable;
b. présentant un allongement sous traction dépassant environ 150% lorsqu'elle est testée à une température inférieure à environ 650°C quand l'axe de contrainte principal se trouve essentiellement dans un plan dans lequel le diamètre mesuré des grains est inférieur à environ 2 µm (microns).

3. Une matière de titane, cette matière:
a. ayant un diamètre moyen de grains inférieur à 2 µm (microns) mesuré dans au moins un plan et consistant en partie en phase alpha métastable contenant jusqu'à 2,5% en volume de particules stables finement dispersées;
b. présentant un allongement sous traction dépassant environ 150% lorsqu'elle est testée à température inférieure à environ 650°C quand l'axe de contrainte principal essentiellement se trouve dans un plan dans lequel la dimension de grains mesurée est inférieure à environ 2 µm (microns).

4. Une matière de titane selon la revendication 3 dans laquelle les particules ont un diamètre moyen inférieur à environ 200 Å [200°] et un écartement entre particules moyens inférieur à environ 1000 Å [1000°].

5. Une matière de titane selon la revendication 3 dans laquelle les particules sont choisies dans le groupe consistant en TiB et oxydes de terres-rares et des mélanges de ceux-ci.

6. Une matière de titane selon la revendication 3 dans laquelle les particules sont essentiellement du TiB.

7. Une matière de titane selon la revendication 3 dans laquelle les particules sont essentiellement des oxydes de terres-rares.

8. Une matière de titane, cette matière:
a. ayant une dimension de grains moyenne inférieure à environ 2 µm (microns) mesurée dans au moins un plan et consistant essentiellement en grains alpha contenant 0,5% en volume à 2,5% en volume de particules stables finement dispersées;
b. présentant un allongement sous traction dépassant environ 150% lorsqu'elle est testée à une température inférieure à environ 650°C quand l'axe de contrainte principal essentiellement se trouve dans un plan dans lequel le diamètre de grains mesuré est inférieur à environ 2 µm (microns).

9. Une matière de titane selon la revendication 8 dans laquelle les particules ont un diamètre moyen inférieur à environ 200 Å [200°] et un écartement entre particules moyen inférieur à environ 1000 Å [1000°].

10. Une matière de titane selon la revendication 8 dans laquelle les particules sont choisies dans le groupe consistant en TiB et oxydes de terres-rares et des mélanges de ceux-ci.

11. Une matière de titane selon la revendication 8 dans laquelle les particules sont essentiellement du TiB.

12. Une matière de titane selon la revendication 8 dans laquelle les particules sont essentiellement des oxydes de terres-rares.

13. Une matière de titane, cette matière:
a. ayant une dimension moyenne de grains inférieure à 2 µm (microns) mesurée dans au moins un plan et consistant essentiellement en grains bêta contenant 0,5% en volume à 2,5% en volume de particules stables et finement dispersées;
b. présentant un allongement sous tension excédant environ 150% lorsqu'elle est testée à température inférieure à environ 650°C lorsque l'axe de contrainte principal est essentiellement dans un plan dans lequel le diamètre moyen des grains est inférieur à environ 2 µm (microns).

14. Une matière de titane selon la revendication 13 dans laquelle les particules ont un diamètre moyen inférieur à environ 200 Å [200°] et un écartement entre particules moyens inférieur à environ 1000 Å [200°].

15. Une matière de titane selon la revendication 13 dans laquelle les particules sont choisies dans le groupe consistant en TiB et oxydes de terres-rares et des mélanges de ceux-ci.

16. Une matière de titane selon la revendication 13 dans laquelle les particules sont essentiellement du TiB.

17. Une matière de titane selon la revendication 13 dans laquelle les particules sont essentiellement des oxydes de terres-rares.
